**Europäisches Patentamt**

**European Patent Office**

**Office européen des brevets**

(11) Veröffentlichungsnummer: **0 222 280**
**A2**

(12) **EUROPÄISCHE PATENTANMELDUNG**

(21) Anmeldenummer: 86115157.9

(22) Anmeldetag: 31.10.86

(51) Int. Cl.⁴: **H01L 29/74**

(30) Priorität: 04.11.85 DE 3539097

(43) Veröffentlichungstag der Anmeldung:
**20.05.87 Patentblatt 87/21**

(84) Benannte Vertragsstaaten:
**DE FR GB IT**

(71) Anmelder: **Siemens Aktiengesellschaft Berlin und München**
**Wittelsbacherplatz 2**
**D-8000 München 2(DE)**

(72) Erfinder: **Stoisiek, Michael, Dr.**
**Ostpreussenstrasse 6**
**D-8012 Ottobrunn(DE)**
Erfinder: **Schmid, Horst, Dipl.-Ing.**
**Stemplingeranger 12**
**D-8000 München 83(DE)**
Erfinder: **Strack, Helmut, Dr. phil.**
**Speyererstrasse 6**
**D-8000 München 40(DE)**

(54) **Thyristor mit steuerbaren Emitter-Basis-Kurzschlüssen.**

(57) Ein Thyristor mit einen pnpn-Halbleiterkörper weist randseitig zu einem der Emitterschichten (1) als steuerbare Emitter-Basis-Kurzschlüsse dienende MIS-FET-Strukturen (9, 12 bis 16) auf. Jede dieser Strukturen besteht aus einem in die Emitterschicht eingefügten Halbleitergebiet (9), das von der dieser Emitterschicht (1) zugeordneten Elektrode (6) kontaktiert wird, aus einem Teilbereich (12) der angrenzenden Basisschicht (2), aus einem dazwischenliegenden Kanalbereich (13), der aus einer randseitigen Zone der Emitterschicht (1) gebildet ist, und aus einem den Kanalbereich isoliert überdeckenden Gate (15). Dieses Gate überdeckt auch den Teilbereich (12) der Basisschicht (2) und bildet mit diesem einen MIS-Kondensator (C1). Über einen Spannungsgenerator (23) wird das Gate (15) mit einer Spannung belegt, die zwischen einem ersten und einem zweiten Spannungswert alterniert. Beim Übergang vom ersten, unter der Einsatzspannung des Kanalbereichs (13) liegenden Spannungswert zum zweiten, der der Einsatzspannung des Teilbereichs (12) der Basisschicht möglichst angenähert ist, zündet der Thyristor infolge des als Zündstrom wirkenden Verschiebestroms des MIS-Kondensators (C1), beim Übergang vom zweiten auf den ersten wird er gelöscht.

**FIG 1**

## Thyristor mit steuerbaren Emitter-Basis-Kurzschlüssen

Die Erfindung bezieht sich auf einen Thyristor nach den Oberbegriffen der Ansprüche 1 oder 2.

Ein Thyristor dieser Art ist aus der DE-A-29 45 324 bekannt. Hierbei ist eine als steuerbarer Emitter-Basis-Kurzschluß dienende MIS-Struktur am Rande der n-Emitterschicht vorgesehen. Sie umfaßt ein in die n-Emitterschicht eingefügtes p-leitendes Halbleitergebiet, einen Teilbereich der p-Basisschicht und einen dazwischenliegenden, aus einer Randzone des n-Emitters gebildeten Kanalbereich, wobei der Kanalbereich von einem von der Grenzfläche des Halbleiterkörpers durch eine Isolierschicht getrennten Gate überdeckt ist. Durch Zuführung eines das Gate gegen die Kathode negativ vorspannenden Impulses wird im Kanalbereich unterhalb des Gate ein erster p-leitender Inversionskanal aufgebaut, der das p-leitende Halbleitergebiet und damit die mit diesem verbundene kathodenseitige Elektrode mit der p-Basis niederohmig verbindet. Während des Auftretens dieses Impulses wird somit der durch die MIS-Struktur gebildete Emitter-Basis-Kurzschluß wirksam geschaltet. Hierdurch wird der Thyristor gelöscht, d.h. aus dem stromführenden Zustand in den gesperrten Zustand übergeführt.

Zusätzlich ist bei dem bekannten Thyristor eine weitere, gleichartige MIS-Struktur vorgesehen, in der bei spannungslosem Gate ein p-leitender Inversionskanal wirksam geschaltet ist. Dieser verhindert eine unbeabsichtigte Zündung des Thyristors. Soll nun die Zündung erfolgen, so wird dem Gate dieser MIS-Struktur ein positiver Spannungsimpuls zugeführt, wobei für die Dauer des Anliegens dieses Impulses der letztere Inversionskanal unwirksam geschaltet ist.

Der Erfindung liegt die Aufgabe zugrunde, einen Thyristor der eingangs genannten Art anzugeben, bei dem sowohl die Zündung als auch die Löschung durch eine Spannungsansteuerung des Gates ein und derselben, als steuerbarer Emitter-Basis-Kurzschluß ausgebildeten MIS-Struktur erfolgen kann. Das wird durch eine Ausbildung nach den kennzeichnenden Merkmalen der Ansprüche 1 oder 2 erreicht.

Der mit der Erfindung erzielbare Vorteil liegt insbesondere in einer einfachen Ausbildung und Ansteuerung der vorgesehenen MIS-Strukturen, die eine wirkungsvolle Zündung oder Löschung des Thyristors gewährleisten. Eine Weiterbildung des erfindungsgemäßen Thyristors, bei der einer der Emitter in eine Mehrzahl von Emitterzonen aufgeteilt ist, an deren Rändern jeweils als Emitter-Basis-Kurzschlüsse dienende MIS-Strukturen der beanspruchten Art angeordnet sind, zeichnet sich dadurch aus, daß eine weitgehend gleichzeitige Zündung des Thyristors in den Bereichen der einzelnen Emitterzonen erzielt wird, was eine große Anstiegsgeschwindigkeit des durch den Thyristor fließenden Laststromes erlaubt.

Die Ansprüche 2 bis 7 sind auf bevorzugte Weiterbildungen und Ausgestaltungen der Erfindung gerichtet.

Die Erfindung wird nachfolgend anhand der Zeichnung näher erläutert. Dabei zeigt:

Figur 1 den Querschnitt eines nach der Erfindung ausgebildeten Thyristors im gesperrten Zustand,

Figur 2 den Thyristor nach Figur 1 während der Zündung,

Figur 3 den Thyristor nach Figur 1 im stromführenden Zustand und

Figur 4 einen weiteren erfindungsgemäß ausgebildeten Thyristor.

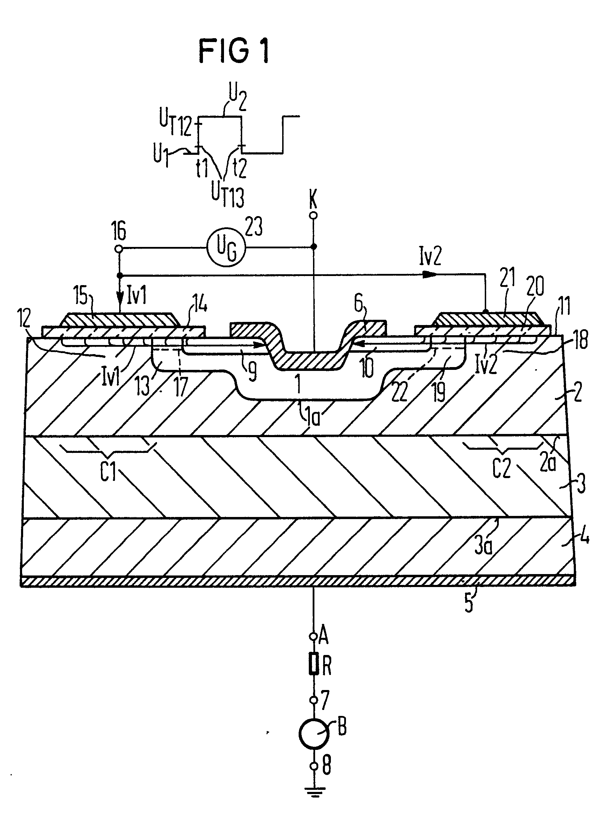

In Figur 1 ist ein Thyristor mit einem aus dotiertem Halbleitermaterial, z.B. Silizium, bestehenden Halbleiterkörper dargestellt. Er weist vier aufeinanderfolgende Schichten abwechselnder Leitungstypen auf. Von diesen bezeichnet man die n-leitende Schicht 1 als den n-Emitter, die p-leitende Schicht 2 als die p-Basis, die n-leitende Schicht 3 als die n-Basis und die p-leitende Schicht 4 als den p-Emitter. Der p-Emitter 4 ist mit einer anodenseitigen Elektrode 5 aus elektrisch leitendem Material, z.B. Aluminium, versehen, die einen Anschluß A aufweist. Der n-Emitter wird von einer mit einem Anschluß K versehenen kathodenseitigen Elektrode 6 aus elektrisch leitendem Material, z.B. Aluminium, kontaktiert. Der pn-Übergang zwischen den Basisschichten 2 und 3 ist mit 2a bezeichnet, der pn-Übergang zwischen 1 und 2 mit 1a und der pn-Übergang zwischen 3 und 4 mit 3a.

Vom Anschluß A gelangt man über einen Lastwiderstand R zum ersten Anschluß 7 einer Spannungsquelle B, die eine Spannung U von z.B. 1000 Volt liefert. Der zweite Anschluß 8 von B liegt auf Massepotential und ist mit dem Anschluß K verbunden.

In den n-Emitter 1 sind p-leitende Halbleitergebiete 9 und 10 eingefügt, die sich bis zur oberen Grenzfläche 11 des Halbleiterkörpers erstrecken und von der Elektrode 6 kontaktiert werden. Das Halbleitergebiet 9 bildet zusammen mit einem sich linksseitig an die n-Emitterschicht anschließenden Teilbereich 12 der p-Basisschicht 2 und einer Randzone 13 der n-Emitterschicht 1, die einen Kanalbereich darstellt und von einem durch eine dünne elektrisch isolierende Schicht 14 von der Grenzfläche 11 getrennten Gate 15 überdeckt ist, eine MIS-FET-Struktur, die über einen Anschluß 16 des Gate 15 ansteuerbar ist. In einem ersten Schaltzustand dieser Struktur liegt bei 16 eine Gatespannung an, die negativer ist als die Einsatzspannung des Kanalbereichs 13 oder dieser entspricht. Dabei baut sich im Kanalbereich 13 unterhalb von 15 ein Inversionskanal 17 auf, der das Gebiet 9 und damit die kathodenseitige Elektrode 6 niederohmig mit dem Teilbereich 12 und damit mit der p-Basisschicht 2 verbindet, d.h. den pn-Übergang zwischen den Schichten 1 und 2 praktisch kurzschließt. In einem zweiten Schaltzustand der MIS-FET-Struktur 9 und 12 bis 16 ist der Anschluß 16 mit einer Spannung belegt, die die Einsatzspannung des Kanalbereichs 13 übersteigt. In diesem Schaltzustand ist der Inversionskanal nicht vorhanden, so daß die niederohmige Verbindung zwischen 9 und 12 bzw. der Kurzschluß zwischen den Schichten 1 und 2 beseitigt ist.

In analoger Weise bildet das von der kathodenseitigen Elektrode 6 kontaktierte p-leitende Halbleitergebiet 10 zusammen mit einem Teilbereich 18 der p-Basisschicht 2 und einer Randzone 19 der n-Emitterschicht 1, einer dünnen elektrisch isolierenden Schicht 20 und einem über den Anschluß 16 ansteuerbaren Gate 21 eine weitere MIS-FET-Struktur. Auch diese weist einen Inversionskanal 22 auf, der wegen der gemeinsamen Ansteuerung beider MIS-FET-Strukturen in Abhängigkeit vom jeweiligen Schaltzustand derselben jeweils gleichzeitig mit dem Inversionskanal 17 vorhanden ist oder nicht.

Die Gates 15 und 21 sind nun ebenso wie die dünnen isolierenden Schichten 14 und 20 so großflächig ausgebildet, daß sie außerhalb der lateralen Begrenzungen der n-Emitterschicht 1 die sich an diese jeweils anschließenden Teilbereiche 12 und 18 der p-Basisschicht 2 mit überdecken. Dabei bilden ihre die Teilbereiche 12 und 18 überdeckenden Teile zusammen mit diesen Teilbereichen und den dazwischenliegenden Teilen der Schichten 14 und 20 jeweils MIS-Kondensatoren C1 und C2.

Zwischen die Anschlüsse 16 und K ist ein Spannungsgenerator 23 geschaltet, der eine zwischen einem ersten Spannungswert $U_1$ und einem zweiten Spannungswert $U_2$ alternierende Spannung abgibt. Solange nun eine Gatespannung $U_G = U_1$ am Anschluß 16 anliegt, die kleiner ist als die Einsatzspannung $U_{T13}$ des Kanalbereichs 13, sind die Inversionskanäle 17 und 22 vorhanden. Dabei befindet sich der Thyristor im gesperrten Zustand, den Figur 1 zeigt. Beginnt die Spannung $U_G$ zum Zeitpunkt t1 anzusteigen, so fließt zunächst, d.h. im Variationsbereich der Gatespannung von $U_1$ bis $U_{T13}$, ein den MIS-Kondensator C1 umladender Verschiebestrom lv1 von 23 über den Anschluß 16 zum Gate 15 und vom Teilbereich 12 über den Inversionskanal 17 und das Gebiet 9 zur Elektrode 6. Analog hierzu fließt ein weiterer Verschiebestrom lv2, der C2 umlädt, über den Inversionskanal 22 zur Elektrode 6.

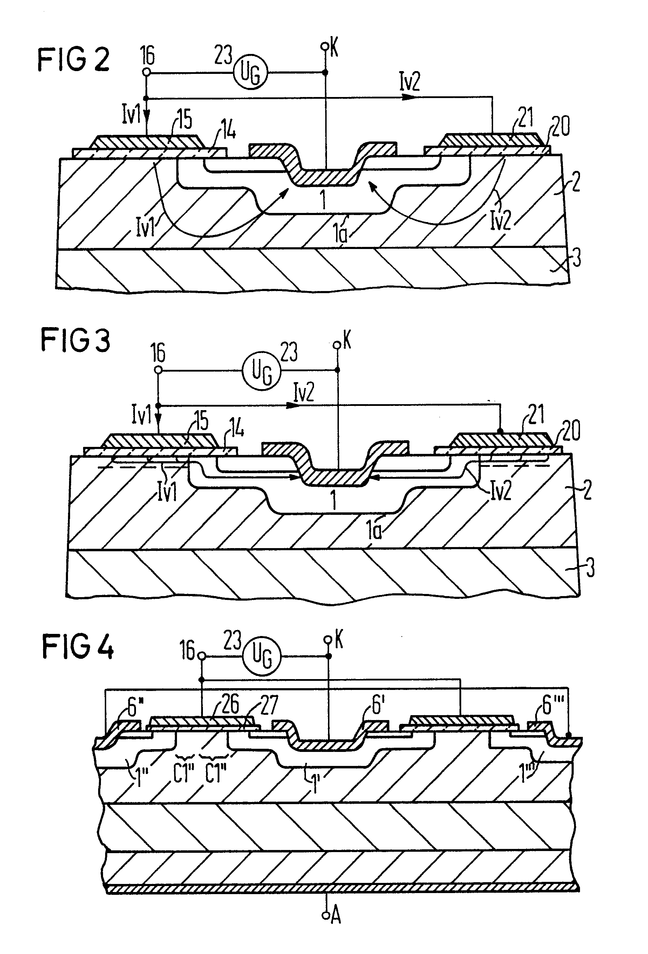

Steigt $U_G$ über $U_{T13}$ hinaus weiter an, so sind die Inversionskanäle 17 und 22 nicht mehr vorhanden. Diesen Zustand des Thyristors zeigt Figur 2. Die Verschiebeströme lv1 und lv2 fließen über den kurzschlußfreien pn-Übergang 1a zur n-Emitterschicht 1. Damit sind diese Verschiebeströme als Zündströme aufzufassen, die die Zündung des Thyristors bewirken. Dies gilt jedoch nur so lange, bis die ansteigende Gatespannung $U_G$ den Wert der Einsatzspannung $U_{T12}$ der Teilbereiche 12 und 18 der p-Basisschicht 2 erreicht hat oder diesen überschreitet. Ist das der Fall, so bilden sich. gemäß Figur 3 Inversionsschichten 24 und 25 in den Teilbereichen 12 und 18 der p-Basisschicht 2 bzw. im Bereich der MIS-Kondensatoren C1 und C2 aus, über die die Verschiebeströme lv1 und lv2 direkt in die n-Emitterschicht 1 und von dort zur Elektrode 6 abfließen. Im Variationsbereich der Gatespannung von $U_{T12}$ bis $U_2$ können Verschiebeströme also nicht mehr die Wirkung von Zündströmen entfalten.

Geht man davon aus, daß $U_G$ zum Zeitpunkt $T_1$ von $U_1$ auf $U_2$ anzusteigen beginnt, und nimmt man an, daß der Variationsbereich der Gatespannung von $U_{T13}$ bis $U_{T12}$ in einer Zeitspann $\Delta t$ linear durchlaufen wird, so ergibt sich pro Flächeneinheit eines der MIS-Kondensatoren, z.B. C1, ein wirksamer Zündstrom $I_B$, der folgender Beziehung genügt:

$$I_B = (U_{T12} - U_{T13}) \cdot C1/\Delta t.$$

Bei einer Spannungsdifferenz zwischen $U_{T12}$ und $U_{T13}$ von z.B. 6,6 Volt, einer Dicke der isolierenden Schicht 14 von 80 nm und $\Delta t = 100$ ns ergab sich für $I_B$ etwa ein Wert von 0,44 A/cm².

Nach der Zündung des Thyristors fließt ein Laststrom in dem die Spannungsquelle B enthaltenden Stromkreis 7, R, A, K und 8. Wird dann zum Zeitpunkt t2 die von 23 gelieferte Gatespannung vom Wert $U_2$ wieder auf den Wert $U_1$ reduziert, so wird der Thyristor beim Erreichen von $U_{T13}$ durch die Gatespannung infolge der Wirksamschaltung der Inversionskanäle 17 und 22 wieder gelöscht.

Dabei erfolgt sowohl das Zünden als auch das Löschen des Thyristors durch eine Spannungsansteuerung derselben Gates, z.B. 15 und 21, der MIS-FET-Strukturen. Je größer die laterale Flächenausdehnung der MIS-Kondensatoren, z.B. C1 und C2, gewählt wird, desto größer ist der erreichbare Zündstrom. Eine weitere Steigerung der Zündwirkung läßt sich erreichen, wenn die p-Basisschicht 2 in den Bereichen 12 und 18 bis auf eine Eindringtiefe, die etwa der Eindringtiefe der n-Emitterschicht 1 entspricht, höher dotiert ist als in ihren übrigen Teilen. Hierdurch erhöhen sich unter sonst gleichen Bedingungen die Verschiebeströme Iv1 und Iv2.

Figur 4 zeigt eine bevorzugte Weiterbildung der Erfindung, bei der die n-Emitterschicht 1 in eine Mehrzahl von Emitterzonen 1′, 1′′ und 1′′′ aufgeteilt ist, die von jeweils zugeordneten, untereinander elektrisch leitend verbundenen Teilen 6′, 6′′ und 6′′′ der Elektrode 6 kontaktiert werden. Eine Mehrzahl von in der beschriebenen Weise ausgebildeten MIS-FET-Strukturen sind jeweils randseitig zu den Emitterzonen vorgesehen. Die Ansteuerung aller dieser Strukturen erfolgt gemeinsam über einen Spannungsgenerator. Dabei weisen die MIS-FET-Strukturen zweier zueinander benachbarter Emitterzonen, z.B. 1′ und 1′′, ein gemeinsames Gate 26 und eine gemeinsame dünne elektrisch isolierende Schicht 27 auf. Unterhalb desjenigen Teiles des Gate 26, das den Zwischenraum zwischen den benachbarten Emitterzonen überdeckt, sind dann zwei einander benachbarte MIS-Kondensatoren, z.B. C1′ und C1′′, vorhanden, die den benachbarten Emitterzonen, z.B. 1′ und 1′′, jeweils zugeordnet sind. Da jede Emitterzone bezüglich ihres Zündstromes aus ihrer unmittelbaren Umgebung angesteuert wird, ermöglicht eine solche Weiterbildung bei einer Aufteilung der n-Emitterschicht in sehr viele gleichmäßig über die Thyristorfläche verteilte Emitterzonen eine weitgehend homogene Zündung der gesamten Thyristorfläche. Das erlaubt eine große Anstiegsgeschwindigkeit des durch den Thyristor fließenden Laststromes.

Die in Figur 4 dargestellten Emitterzonen 1′, 1′′ usw. sind vorzugsweise langgestreckt bzw. streifenförmig ausgebildet und verlaufen geradlinig oder längs irgendwelcher gekrümmter Linien über die ganze Tyristorfläche. Andererseits können die Emitterzonen 1′′, 1′′′ usw. auch als konzentrische Ringe ausgebildet und konzentrisch zu der innersten Emitterzone 1′ angeordnet sein, wobei dann die letztere ringförmig ausgebildet ist. In Figur 1 kann die n-Emitterschicht 1 auch langgestreckt oder kreisförmig ausgebildet sein, wobei im letzteren Fall die Bezugszeichen 9 und 10, 14 und 20, 15 und 21, C1 und C2 jeweils ein und demselben, ringförmig ausgebildeten Strukturteil zugeordnet sind.

Im Rahmen der Erfindung kann auch der p-Emitter des Thyristors mit den beschriebenen MIS-FET-Strukturen versehen sein, die dann sowohl zur Zündung als auch zum Löschen des Thyristors über einen Spannungsgenerator angesteuert werden. Zur Veranschaulichung dieser Ausführungsformen der Erfindung können die Figuren 1 bis 4 dienen, wenn die Leitungstypen der einzelnen Halbleiterteile und die Polaritäten der angelegten Spannungen durch die jeweils entgegengesetzten ersetzt werden.

## Ansprüche

1. Thyristor mit einem Halbleiterkörper, der eine von einer kathodenseitigen Elektrode kontaktierte n-Emitterschicht mit einer angrenzenden p-Basisschicht und eine von einer anodenseitigen Elektrode kontaktierte p-Emitterschicht mit einer angrenzenden n-Basisschicht aufweist, wobei die Basisschichten durch einen pn-Übergang voneinander getrennt sind; bei dem am Rande der n-Emitterschicht wenigstens eine als steuerbarer Emitter-Basis-Kurzschluß dienende, erste MIS-Struktur vorgesehen ist, welche ein in die n-Emitterschicht eingefügtes p-leitendes Halbleitergebiet, einen Teilbereich der p-Basisschicht und einen dazwischenliegenden, aus einer randseitigen Zone der n-Emitterschicht gebildeten ersten Kanalbereich umfaßt, wobei der erste Kanalbereich von einem von der Grenzfläche des Halbleiterkörpers durch eine erste Isolierschicht getrennten, ersten Gate überdeckt ist, **dadurch gekennzeichnet,** daß das erste Gate (15) auch den Teilbereich (12) der p-Basisschicht (2) isoliert überdeckt, daß zwischen die kathodenseitige Elektrode (6) und das erste Gate (15) ein erster Spannungsgenerator - (23) geschaltet ist, der eine zwischen einem ersten und einem zweiten Spannungswert alternierende Spannung erzeugt, daß der erste Spannungswert unterhalb der Einsatzspannung des ersten Kanalbereichs (13) liegt, daß der zweite Spannungswert der Einsatzspannung des Teilbereiches (12) der p-Basisschicht möglichst angenähert ist oder diese übersteigt und daß die Zündung des Thyristors durch den Übergang vom ersten auf den zweiten Spannungswert und das Löschen desselben durch den Übergang vom zweiten auf den ersten Spannungswert bestimmt werden.

2. Thyristor mit einem Halbleiterkörper, der eine von einer kathodenseitigen Elektrode kontaktierte n-Emitterschicht mit einer angrenzenden p-Basisschicht und eine von einer anodenseitigen Elektrode kontaktierte p-Emitterschicht mit einer angrenzenden n-Basisschicht aufweist, wobei die Basisschichten durch einen pn-Übergang voneinander getrennt sind, bei dem am Rande der p-Emitterschicht wenigstens eine als steuerbarer Emitter-Basis-Kurzschluß dienende, zweite MIS-Struktur vorgesehen ist, welche ein in die p-Emitterschicht eingefügtes n-leitendes Halbleitergebiet, einen Teilbereich der n-Basisschicht und einen dazwischenliegenden, aus einer randseitigen Zone der p-Emitterschicht gebildeten zweiten Kanalbereich umfaßt, wobei der zweite Kanalbereich von einem von der Grenzfläche des Halbleiterkörpers durch eine zweite Isolierschicht getrennten, zweiten Gate überdeckt ist, **dadurch gekennzeichnet,** daß das zweite Gate auch den Teilbereich der n-Basisschicht isoliert überdeckt, daß zwischen die anodenseitige Elektrode und das zweite Gate ein zweiter Spannungsgenerator geschaltet ist, der eine zwischen einem dritten und einem vierten Spannungswert alternierende Spannung erzeugt, daß der dritte Spannungswert oberhalb der Einsatzspannung des zweiten Kanalbereiches liegt, daß der vierte Spannungswert der Einsatzspannung des Teilbereiches der n-Basisschicht möglichst angenähert ist oder diese unterschreitet und daß die Zündung des Thyristors durch den Übergang vom dritten auf den vierten Spannungswert und das Löschen desselben durch den Übergang vom vierten auf den dritten Spannungswert bestimmt werden.

3. Thyristor nach Anspruch 1 oder 2, **dadurch gekennzeichnet,** daß eine der Emitterschichten aus einer Mehrzahl von Emitterzonen (1', 1'', 1''') besteht, die mit jeweils zugeordneten untereinander elektrisch leitend verbundenen Teilen (6', 6'', 6''') der diese Emitterschicht kontaktierenden Elektrode versehen sind und daß eine Mehrzahl von als steuerbare Emitter-Basis-Kurzschlüsse dienenden MIS-Strukturen jeweils an den Rändern der Emitterzonen vorgesehen sind.

4. Thyristor nach Anspruch 3, **dadurch gekennzeichnet,** daß die Emitterzonen (1', 1'', 1''') langgestreckt ausgebildet sind und etwa parallel zueinander über die ganze Thyristorfläche verlaufen.

5. Thyristor nach Anspruch 3, **dadurch gekennzeichnet,** daß die Emitterzonen (1'', 1''') in Form von Kreisringen ausgebildet und konzentrisch zueinander und zu der kreisförmig ausgebildeten innersten Emitterzone (1') angeordnet sind.

6. Thyristor nach einem der Ansprüche 1 und 3 bis 5, **dadurch gekennzeichnet,** daß die p-Basisschicht (2) unterhalb der Gates (15, 21), ausgehend von der Oberfläche (11) des Halbleiterkörpers bis zu einer Eindringtiefe, die etwa der der n-Emitterschicht (1) entspricht, höher dotiert ist als in ihren übrigen Teilen.

7. Thyristor nach einem der Ansprüche 2 bis 5, **dadurch gekennzeichnet,** daß die n-Basisschicht im Bereich der Gates, ausgehend von der Oberfläche des Halbleiterkörpers bis zu einer Eindringtiefe, die etwa der der p-Emitterschicht entspricht, höher dotiert ist als in ihren übrigen Teilen.

# FIG 1

FIG 2

FIG 3

FIG 4